(19) Europäisches Patentamt / European Patent Office / Office européen des brevets

(11) **EP 2 250 654 B1**

## (12) EUROPEAN PATENT SPECIFICATION

(45) Date of publication and mention
of the grant of the patent:
**31.08.2016 Bulletin 2016/35**

(21) Application number: **09716207.7**

(22) Date of filing: **04.03.2009**

(51) Int Cl.:
*H01F 38/00* (2006.01)    *H01B 9/02* (2006.01)
*H02G 7/20* (2006.01)

(86) International application number:
**PCT/IB2009/000445**

(87) International publication number:
**WO 2009/109847 (11.09.2009 Gazette 2009/37)**

(54) **PASSIVE-SHIELDING SYSTEM OF A MESHED AND CONDUCTIVE TYPE WITH HIGH MAGNETIC COUPLING**

PASSIVES LEITENDES MASCHENARTIGES ABSCHIRMUNGSSYSTEM MIT HOHER MAGNETKOPPLUNG

SYSTÈME DE PROTECTION PASSIVE DE TYPE MAILLE ET CONDUCTEUR AVEC COUPLAGE MAGNÉTIQUE ÉLEVÉ

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **07.03.2008 IT TO20080176**

(43) Date of publication of application:
**17.11.2010 Bulletin 2010/46**

(73) Proprietor: **SATI SHIELDING S.r.l.**
**10098 Cascine Vica - Rivoli (TO) (IT)**

(72) Inventors:
• **GIACCONE, Luca**
**I-12017 Robilante (Cuneo) (IT)**
• **CANOVA, Aldo**
**I-10129 Torino (IT)**

(74) Representative: **Marchitelli, Mauro et al**
**Via Maria Vittoria 18**
**10123 Torino (IT)**

(56) References cited:
**DE-A1- 19 831 178**    **SE-B- 460 447**
**US-A1- 2005 073 200**

• **D'AMORE M ET AL: "New double-shielded power cables generating low magnetic field levels" ELECTROMAGNETIC COMPATIBILITY, 2005. EMC 2005. 2005 INTERNATIONAL SYMP OSIUM ON CHICAGO, IL, USA 8-12 AUG. 2005, PISCATAWAY, NJ, USA,IEEE, vol. 1, 8 August 2005 (2005-08-08), pages 179-184, XP010839144 ISBN: 978-0-7803-9380-6**

**Description**

The present invention relates to techniques of mitigation of magnetic fields produced by the electric power lines for carrying and distributing electrical energy.

Electric power lines, whether underground lines or overhead lines, which carry energy are traversed by electric currents, in general of a sinusoidal type and with amplitude variable in time according to the electrical load, which generate magnetic fields in the surrounding space. The need to reduce said magnetic fields to levels deemed compatible with human health or with regular operation of devices of various types has led to the definition, by means of technical rules or laws, the reference levels that are not to be exceeded.

Normally, the conductors of the source are arranged according to operating requirements (dimensions of the excavation in the case of buried lines) or functional requirements (requirements of thermal dissipation).

In certain cases, the configuration of the lines or the values of current do not enable respect of said guard levels, and it is hence necessary to provide systems for mitigation of magnetic fields.

The performance of a shield is defined by the ratio between the values of magnetic induction in a given point in the absence and in the presence of the shield. Said coefficient is defined as "shielding factor" and is a number greater than unity. The greater the shielding factor, the more the shield is able to perform its function.

The shielding factor is defined as a point quantity and is hence a function of the point of space in which it is calculated. Typically assumed as significant point is the point characterized by the maximum value of the magnetic field: in the case of buried lines, a point at the level of the ground set symmetrically with respect to the electric power line to be shielded is assumed.

Mitigation systems, also referred to as "shields", are divided into two major categories: passive shields and active shields.

The former are characterized in that they do not require external electrical sources for their supply, whereas the latter require an external supply. In either case, the shields are set in the proximity of the source and of the region in which it is intended to mitigate the magnetic field.

As regards passive shields, they are divided into two categories: ferromagnetic shields and conductive shields. The former are constituted by plates of ferromagnetic material that intercept the magnetic field to be shielded reducing it in the surrounding region.

Typically said systems are used in the case of buried lines, and the plates of ferromagnetic material are set underground in the proximity of the electric power line. Given that the values of the magnetic field are in general low (expressed in units of magnetic induction of the order of microtesla and millitesla), the ferromagnetic shields require the use of materials characterized by a high magnetic permeability at low magnetic fields (referred to as "initial magnetic permeability").

Passive conductive shields are characterized by plates of conductive material, typically aluminium or copper, the working principle of which is based upon the law of electromagnetic induction: the magnetic field to be shielded induces in the plates eddy currents, referred to as "Foucault currents", which generate a field that opposes said magnetic field.

Conductive shields constituted by plates, like ferromagnetic ones, are used for shielding the fields produced by the underground lines and are generally buried in the ground and set between the electric power line that generates the magnetic field and the region in which it is intended to reduce the field. In order to guarantee proper operation of this type of shields, it is necessary for the plates that make them up to be firmly welded together in order to guarantee a good electrical continuity of the entire shield.

A particular type of conductive shields is represented by passive meshes. Said shields are constituted by cylindrical electric conductors (typically the same electric cables used for carrying and distributing the energy) connected to one another to form closed meshes. Operation thereof is again based upon the principle of the law of electromagnetic induction: the magnetic field to be shielded induces within the mesh or meshes of the shield eddy currents that generate in turn a magnetic field that opposes the one to be shielded. This type of shields is used both for overhead electric power lines and for underground ones.

Common passive shields are characterized by relatively low currents (on account of the poor magnetic coupling with the source) and by relatively low shielding factors. They present the advantage that they do not have active components and they self-adjust the mitigation current as a function of the source current. Finally, in order to be able to raise the current induced in the passive shield, capacitors set in series to the conductors are used, which compensate for the inductance of the circuit. This operation enables minimization of the impedance of the circuit (transforming it into a purely resistive circuit) and enables a phase offset to be obtained between the induced current and the source current of approximately 90° (the best condition would be to obtain a shield current in phase opposition, i.e., 180° out of phase, with respect to the source current).

There exist passive shields constituted by mixed ferromagnetic and conductive solutions. In general, they are made up of an alternation of plates of conductive material and ferromagnetic material.

As regards the active shields, they are in general constituted by electric conductors forming more or less complex meshes, which, unlike passive shields in which said meshes are closed in short circuit, are supplied by appropriately controlled current generators. The supply current is modified as the magnetic field that it is necessary to shield varies, and hence said systems necessitate a system for measuring the magnetic field in the region to be shielded and a control system that modulates the current in the shield at the desired value. This type of shield is generally used for overhead lines.

Active shields enable higher shielding factors to be obtained, but it is necessary for the mitigation current to be controlled both in amplitude and in phase as a function of the source current. As compared to passive shield, this enables higher currents to be obtained in the shield, which are in phase opposition with respect to the source. On the other hand, the active shield requires:

- a system for measurement of the source current; and
- a system for supply of the shield; in the presence of an erroneous control, the active shield turns into a new source.

Appearing in the table below are the main characteristics and peculiarities of the different types of shields.

| Type of shield | Shielding factor | Control and maintenance | Difficulty of design | Cost of materials of the shield | Transport and production cost | Problems |
|---|---|---|---|---|---|---|
| Passive conductive with plates | Medium (10-20) | None | Medium | Medium-to-low | High | Access to shielded line for possible maintenance may prove problematical with shield installed |
| | | | | | | Not applicable for overhead lines |
| Passive conductive with meshes | Low (2-5) | None | High | Low | Low (transport cost) | Provision of connections for particularly complex meshes |
| | | | | | Medium (cost of production of production of complex meshes) | |
| Passive ferromagnetic | Medium-to-high (20-30) | None | Medium-to-low | Medium-to-high | Medium-to-high (materials characterized by high initial permeability are necessary) | Access to shielded line for possible maintenance may prove problematical with shield installed. Not applicable for overhead lines |
| Active | High (>50) | Control of the levels of field and of the supply current of the shield required | High | High | Medium-to-high | In the case of erroneous control or supply, the shield turns into a source of field |

More specifically, the present invention relates to a shielding system according to the preamble of Claim 1, which is known, e.g. from D'AMORE M ET AL: "New double-shielded power cables generating low magnetic field levels" ELECTROMAGNETIC COMPATIBILITY, 2005. EMC 2005. 2005 INTERNATIONAL SYMP OSIUM ON CHICAGO, IL, USA 8-12 AUG. 2005, PISCATAWAY, NJ, USA,IEEE, vol. 1, 8 August 2005 (2005-08-08), pages 179-184, XP010839144 ISBN: 978-0-7803-9380-6

Documents SE 460 447 B and DE 198 31 178 may also be of interest for the instant invention.

The system proposed enables mitigation of the magnetic field produced by a source, constituted by a set of conductors traversed by current (electric power line), by means of a second system of conductors with high magnetic coupling with the conductors of the source, arranged appropriately in space and traversed by currents with a suitable phase offset with respect the ones that traverse the conductors of the source (according to what will be described hereinafter). The conductors that perform mitigation can have a number, position, cross section, and current chosen in an optimal way. For currents to be able to circulate in the conductors, these are connected so as to form closed-path circuits.

As in the case of passive conductive shields, mitigation of the field derives from the superposition of the effects of the two systems.

The idea proposed is to provide a passive shield of a meshed type with high coupling with the source, i.e., a shield constituted by a set of conductors appropriately connected to one another in which the currents in the shield are induced through a magnetic coupling obtained by means of a series of torus of magnetic material, appropriately sized and concatenating the sources.

The characteristics and advantages of the present invention will emerge more clearly from the ensuing detailed description of the attached drawings, in which:

- Figure 1 shows the general structure of the high-coupling shielding system, highlighted in which are the field sources 1, the shielding conductors 2, the magnetic core for coupling 3, and the secondary winding 4;
- Figure 2 shows the equivalent three-phase circuit of the shielding system;
- Figure 3 shows the equivalent three-phase circuit in which the configuration that uses a reduced number of cores is adopted;
- Figure 4 shows a shielding system with unit coupling;
- Figures 5A and 5B show the single-phase equivalent circuit of the shielding system;
- Figure 6 shows the scheme that enables division of the shielding current using the connection in series of a number of turns that come to form the shielding phase 2;
- Figure 7 shows the extension of the shielding system to the case of a source with multiconductor phases and a multiconductor shield;
- Figures 8 and 9 show two possible structures of the core suitable for two different structures of the shield; and
- Figure 10 shows the application of the shielding system to a low-voltage output (LV) of a transformer station.

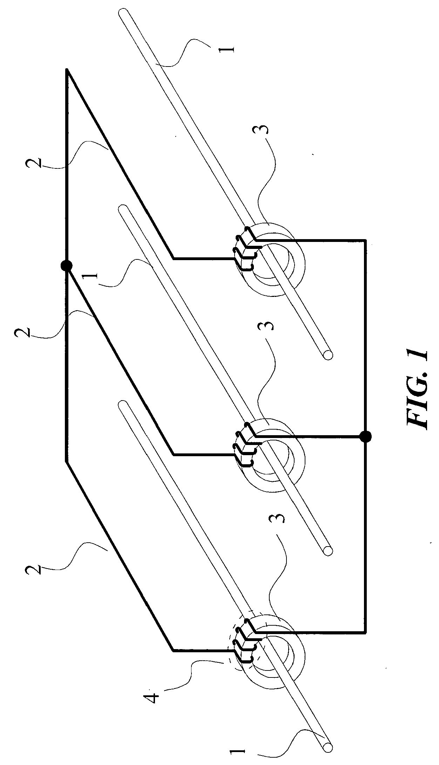

The system presents in principle as in Figure 1.

In said figure, there may be noted the set of three conductors (each representing the phase conductor, in what follows referred to simply as "phase") of the source 1 and the set of three conductors of the shield 2 (one for each phase of the source). Each of the conductors of the shield 2 is parallel to a respective source conductor 1. Each phase of the source 1 concatenates the magnetic core 3 $N_1$ times ($N_1=1$); a winding 4 of $N_2$ turns set on the core 3 supplies one phase of the shield 2. Through the magnetic core 3 there is created a practically ideal magnetic coupling between the phase of the source 1 and the phase of the shield 2.

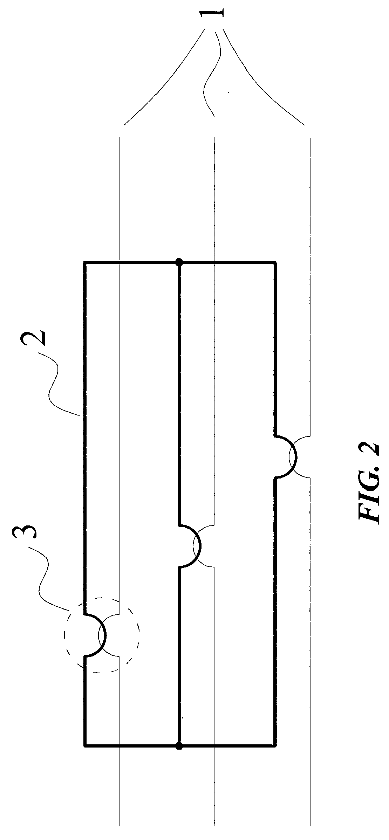

The working principle of the system is shown schematically by the equivalent circuit represented in Figure 2. Each phase of the source 1 represents the primary of a transformer in which the secondary is represented by the phase of the shield 2. The currents in the two phases, source and shield, are hence linked by the transformer ratio: $N_1/N_2$.

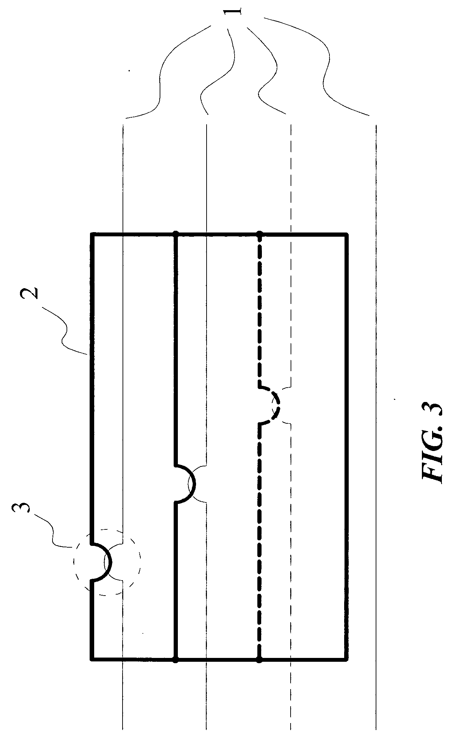

In the scheme of Figure 2 associated to each phase is a core 3; hence, the number of cores is equal to NF, but it is possible to reduce the number of cores to NF-1 as shown in Figure 3.

There exist multiple variants determined by the geometry of the source 1, by the choice of the geometry, and by the ratio $N_1/N_2$.

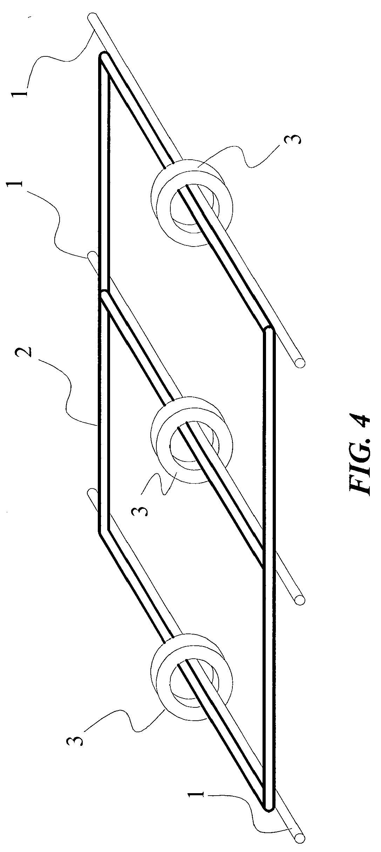

The simplest configuration is the one represented in Figure 4 in which $N_1=1$ and $N_2=1$ (unit coupling). In said configuration, the coupling between the source 1 and the shield 2 is characterized by a transformer ratio equal to unity, and the shield and source currents coincide in amplitude.

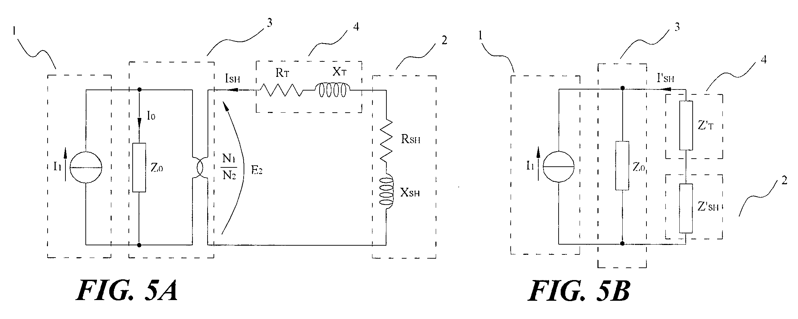

One of the aspects that renders shielding efficient is represented by the fact that the two currents, the source current and the shield current, are of course in phase opposition. With reference to Figure 5, represented therein is the equivalent single-phase circuit of the coupling between the two circuits, where:

- the source 1 is represented by the current generator $I_1$;
- the magnetic core 3 is represented via the model of the transformer, so that: $Z_0$ describes the losses in the iron and the magnetizing current; the transformer ratio describes the coupling between source 1 and the shield 2; resistance and inductive reactance of the winding 4 are, respectively, represented by $R_T$ and $X_T$; finally, $I_{SH}$, $R_{SH}$ and $X_{SH}$ represent, respectively, the induced current, the resistance, and the inductive reactance of the shielding conductor 2.

With reference to Figure 5, we find that the currents are

$$I_{SH} = -\frac{E_2}{(R_T + R_{SH}) + j(X_T + X_{SH})}$$

$$I'_{SH} = I_{SH}\frac{N_2}{N_1}$$

$$I_1 + I'_{SH} = I_0$$

If the core is well sized, the current $I_0$, which comprises losses in the iron and the magnetizing current, is negligible so that we may say

$$I_1 \approx -I'_{SH} = -I_{SH}\frac{N_2}{N_1}$$

Hence, the current that traverses the conductors of the shield 2 is of course in phase opposition with respect to the current of the source 1, and the use compensation capacitances (frequently used in passive loops not only to compensate for the inductance but also to offset the phase of the currents) is avoided.

The design process is based upon sizing of the magnetic core and the choice of the section of the conductors of the shield.

Given the line, we obtain the maximum line current (capacity of the line), which forms the source of the field that is to be shielded.

We define the portion of current, with respect to the source current, that it is intended to use in the shield, namely, $k_{SH}$.

Hence the current that is to traverse the conductors of one phase of the shield is

$$I_{F-SH} = \frac{I_1}{k_{SH}}.$$

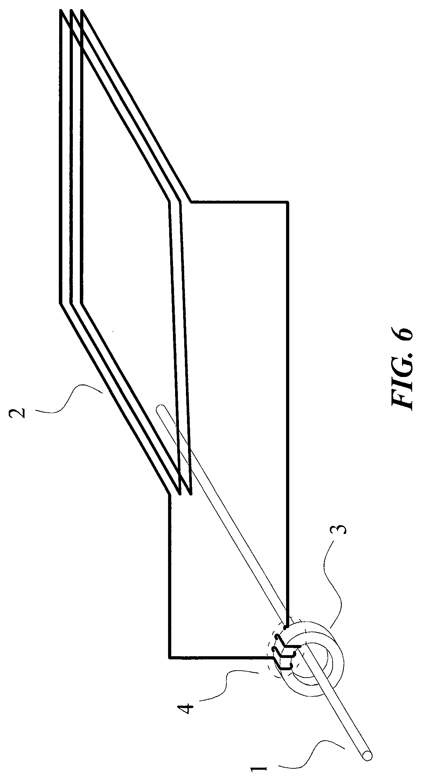

As is shown in Figure 6, the shield current may again be divided into a certain number of subconductors, namely $N_{C-F-SH}$, and hence the current that traverses the individual shield conductor is given by the relation:

$$I_{C-F-SH} = \frac{I_{F-SH}}{N_{C-F-SH}}.$$

It should be noted that this division is convenient in a single-phase shield, whereas in a three-phase shield the return path of the turn would come to constitute a fourth, neutral, wire, which is of no effect for the purposes of shielding. In a three-phase system, hence, the parameter $N_{C-F-SH}$ has a unit value in the majority of cases. In this context, however, it is taken into account in order to provide a design criterion that is as general as possible.

The current $I_{C-F-SH}$ is supplied by the magnetic core that concatenates the current of the source; said current traverses the $N_2$ turns of the magnetic core 3.

By Ampère's law the following equality applies:

$$N_2 I_{F-C-SH} = N_1 I_1$$

whence the number of turns $N_2$ derives

$$N_2 = N_1 N_{C-F-SH} k_{SH}$$

where $N_1$ is in general equal to unity if the source conductor traverses the core just once.

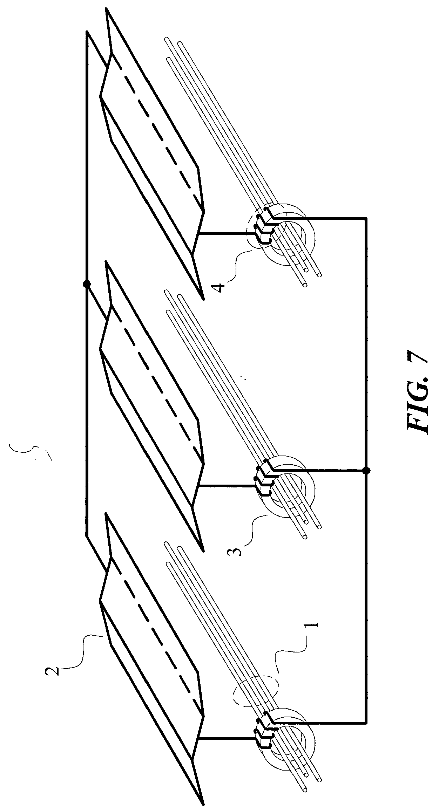

A further variable can be represented by the number of runs of each phase of the shield (Figure 7). In this case, each of the magnetic cores 3 concatenates a set of source conductors 1 and a respective set of shielding conductors 2. If we indicate by "phase of the shield" the set of the conductors $N_{C-F-SH}$ supplied by the individual core, the phase can be constituted by one or more runs in parallel $N_V$. The possibility of increasing the number of runs enables increase of the shielding factor given the same volume of the conductors used. Each run is traversed by a fraction of the phase current of the shield:

$$I_{F-V-SH} = \frac{I_{C-F-SH}}{N_V}$$

The number of subconductors that contribute to shielding a phase, i.e., that come to form the shielding-phase current $I_{F-SH}$, is equal to:

$$N_{V-F-SH} = N_{SH} N_V .$$

Once the geometrical constraints have been defined (generally the maximum dimensions of the space in which the shield is to be located), and once $k_{SH}$, the number of conductors per phase of the shield $N_{C-F-SH}$, and the number of runs $N_V$ have been chosen, the optimal position for the phases and the runs of the shield is then evaluated. The calculation can be made by means of optimization algorithms that seek the configuration that minimizes the magnetic field in a given region.

Sizing of the magnetic core: the magnetic core must be able to supply a voltage sufficient to cause circulation within the conductors of the shield of the current defined. Sizing of the magnetic core is based upon:

- choice of the material (depending upon which is the maximum operating magnetic induction);
- choice of the cross section of the core; and
- internal diameter of the core, which must be sufficient to enable passage of the source conductor and of the winding that supplies the shield.

With reference to the circuit represented in Figure 5, the voltage across the secondary of the transformer must be

$$E_2 = I_{SH} \sqrt{(R_T + R_{SH})^2 + (X_T + X_{SH})^2}$$

Using the value of the saturation induction of the material of which the magnetic core 3 is made ($B_{sat}$), it is hence possible to calculate the cross section of the core as follows:

$$S = \frac{E_2}{\omega B_{sat} N_2}$$

where $\omega$ is the angular pulsation at the mains frequency.

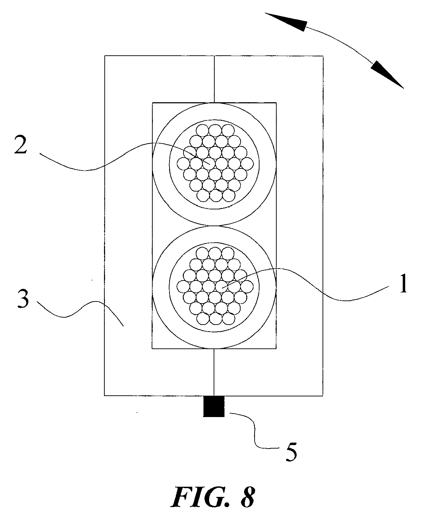

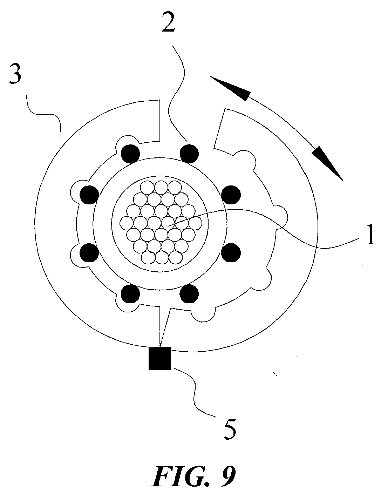

The application *in situ* of the principle set forth enables different variants also as regards the shape of the core. By way of example, some possible geometries of the core are shown. In the diagram of Figure 8 the phase of the shield is represented by a single conductor, whereas in Figure 9 each phase of the shield is divided into a certain number of runs set symmetrically with respect to the phase of the source.

The core must be openable for enabling its installation, so that a core that can be opened via a hinge has been devised.

The invention in question presents the advantage of being applicable to stretches of line that are even very short. This extends use thereof also for the purpose of shielding the start of low-voltage lines in the transformer stations.

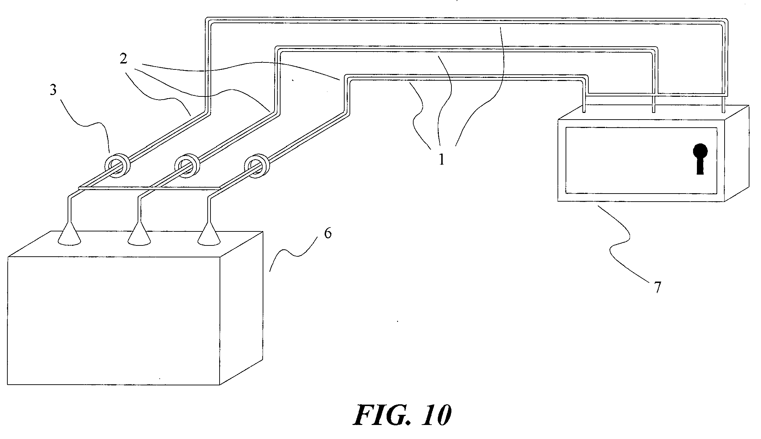

By way of example, presented in Figure 10 is the possible scheme for mitigation of the field produced by the sources 1 that connect the transformer 6 to the main LV switchboard 7.

The system presents considerable advantages:

- it is self-adaptive given that it is a passive shield;
- no systems for supply of the shield are necessary in so far as it is the source itself that, through the magnetic core, supplies the shield;
- the currents are much higher than in traditional passive shields (meshed passive shields or shields with conductive surfaces);
- the currents are of course in phase opposition and hence enable the maximum shielding effect as regards the phase;
- at the same cost as for passive shields, the shielding factor can reach values equal to 20 (meshed passive shields constituted by conductors have a shielding factor of approximately 2-5), whereas active shields are much more costly given the same shielding factor;
- the conductors of the shield can be bare (e.g., stranded conductors) and hence carry high current densities; and
- it is possible to use, in the case of coupling with $N_2=1$, the same conductor used for the source, with considerable advantage from the standpoint of provisioning.

As compared to thin shields (plates made of ferromagnetic or conductive material) a series of advantages, listed below, is obtained.

- Cost: the cost of the magnetic cores is extremely low in so far as it is not necessary to use ferromagnetic materials with particular characteristics (as occurs, for example, in thin ferromagnetic shields where, on account of the low operating magnetic fields, a high initial magnetic permeability is necessary).

Installation: the magnetic core must be positioned around the cable and can hence be constituted by two half-shells that are positioned during installation of the line or even subsequently. It is not necessary to carry out particularly demanding earthworks, as instead is required in the laying of thin shields.

Transport: given that thin shields require complex welding operations, they are frequently not assembled *in* situ and hence, if they are of large dimensions, they involve also use of special means of transport.

**Claims**

1.   A combination of a plurality of source conductors (1) and a shielding system for mitigation of the magnetic field produced by said plurality of source conductors (1) traversed by currents, wherein the source conductors (1) are electric power lines for carrying and distributing electrical energy, the system comprising:

    - a plurality of shielding conductors (2) associated to said plurality of source conductors (1), wherein each of said shielding conductors (2) is parallel to a respective stretch of source conductor (1); and
    - a plurality of magnetic cores (3) concatenating said source conductors (1) and said shielding conductors (2) so as to provide a magnetic coupling between said source conductors (1) and said shielding conductors (2),

wherein the shielding conductors (2) of said plurality are connected to one another so as to form a closed circuit, and are traversed by currents induced by said magnetic coupling
wherein the current that traverses each of said shielding conductors (2) is in phase opposition with respect to the current that traverses the respective source conductor (1),
**characterized in that** each of said magnetic cores (3) has a toroidal shape with an internal opening through which extends at least one of said source conductors (1) and at least one of said shielding conductors (2), wherein each of said magnetic cores (3) is configured to be openable for enabling its installation, such that the magnetic cores can be positioned around said power lines during installation and the system is applicable to stretches of power lines.

2.   The combination according to Claim 1, **characterized in that**:

    - associated to each source conductor (1) is a respective shielding conductor (2) and a respective magnetic core (3);
    - each source conductor (1) concatenates said magnetic core (3) $N_1$ times; and
    - each shielding conductor (2) concatenates said magnetic core (3) $N_2$ times via a winding (4) provided on said magnetic core (3).

3. The combination according to Claim 1, **characterized in that**:

- each source conductor (1) concatenates said magnetic core (3) just once; and
- each shielding conductor (2) concatenates said magnetic core (3) just once.

4. The combination according to Claim 2 or Claim 3, **characterized in that** each magnetic core (3), together with the respective source conductor (1) and the respective shielding conductor (2), provides a transformer.

5. The combination according to Claim 4, **characterized in that** the primary winding of said transformer is provided by a source conductor (1), and the secondary winding of said transformer is provided by the respective shielding conductor (2), and the currents that flow, respectively, in the source conductor (1) and in the shielding conductor (2) are linked by a transformer ratio equal to $N_1/N_2$.

6. The combination according to any one of the preceding claims, **characterized in that** each of said shielding conductors (2) comprises a plurality of subconductors arranged so as to form one turn.

7. The combination according to Claim 1, **characterized in that** the number of cores (3) of magnetic material is smaller than the number of said source conductors (1).

8. The combination according to Claim 1, **characterized in that** each of the magnetic cores (3) concatenates a set of source conductors (1) and a respective set of shielding conductors (2).

9. The combination according to Claim 1, **characterized in that** each of said magnetic cores (3) comprises a hinge.

10. The combination according to Claim 1 or Claim 9, **characterized in that** each of said magnetic cores (3) is constituted by two half-shells to be positioned around the power lines during installation of the power lines or even subsequently.

11. The combination according to any of the previous claims, **characterized in that** said shielding system is applied to the start of the low-voltage lines in the transformer stations.


**Patentansprüche**

1. Kombination einer Mehrzahl von Ursprungsleitern (1) und einem Abschirmungssystem zur Abschwächung des Magnetfelds, das von der Mehrzahl von Ursprungsleitern (1) erzeugt wird, die von Strömen durchlaufen werden, wobei die Ursprungsleiter (1) elektrische Stromleitungen zum Befördern und Verteilen von elektrischer Energie sind, wobei das System umfasst:

- eine Mehrzahl von Abschirmungsleitern (2), die zu der Mehrzahl von Ursprungsleitern (1) gehören, wobei jeder der Abschirmungsleiter (2) parallel zu einer jeweiligen Ausdehnung des Ursprungsleiters (1) ist; und
- eine Mehrzahl von Magnetkernen (3), welche die Ursprungsleiter (1) und die Abschirmungsleiter (2) verknüpfen, um eine magnetische Kopplung zwischen den Ursprungsleitern (1) und den Abschirmungsleitern (2) bereitzustellen,

wobei die Abschirmungsleiter (2) der Mehrzahl miteinander verbunden sind, so dass sie einen geschlossenen Kreis bilden, und wobei sie von Strömen durchlaufen werden, die von der magnetischen Kopplung induziert werden, wobei der Strom, der jeden der Abschirmungsleiter (2) durchläuft, in Gegenphasigkeit in Bezug auf den Strom ist, der den jeweiligen Ursprungsleiter (1) durchläuft, **dadurch gekennzeichnet, dass** jeder der Magnetkerne (3) eine Toroidform mit einer inneren Öffnung hat, durch welche hindurch mindestens einer der Ursprungsleiter (1) und mindestens einer der Abschirmungsleiter(2) verläuft, wobei jeder der Magnetkerne (3) so konfiguriert ist, dass er zum Ermöglichen seiner Installation geöffnet werden kann, so dass die Magnetkerne während der Installation um die Stromleitungen herum angeordnet werden können und das System mit Ausdehnungen von Stromleitungen verwendbar ist.

2. Kombination nach Anspruch 1, **dadurch gekennzeichnet, dass**:

- jedem Ursprungsleiter (1) ein jeweiliger Abschirmungsleiter (2) und ein jeweiliger Magnetkern (3) zugeordnet ist;
- jeder Ursprungsleiter (1) den Magnetkern (3) $N_1$ mal verknüpft; und

- jeder Abschirmungsleiter (2) den Magnetkern (3) $N_2$ mal über eine Wicklung (4) verknüpft, die an dem Magnetkern (3) vorgesehen ist.

3. Kombination nach Anspruch 1, **dadurch gekennzeichnet, dass**:

- jeder Ursprungsleiter (1) den Magnetkern (3) nur einmal verknüpft; und
- jeder Abschirmungsleiter (2) den Magnetkern (3) nur einmal verknüpft.

4. Kombination nach Anspruch 2 oder 3, **dadurch gekennzeichnet, dass** jeder Magnetkern (3), zusammen mit dem jeweiligen Ursprungsleiter (1) und dem jeweiligen Abschirmungsleiter (2), einen Transformator bereitstellt.

5. Kombination nach Anspruch 4, **dadurch gekennzeichnet, dass** die Primärwicklung des Transformators durch einen Ursprungsleiter (1) bereitgestellt wird, und dass die Sekundärwicklung des Transformators durch den jeweiligen Abschirmungsleiter (2) bereitgestellt wird, und dass die Ströme, die jeweils in dem Ursprungsleiter (1) und in dem Abschirmungsleiter (2) fließen, mit einem Transformatorverhältnis gleich $N_1/N_2$ verknüpft sind.

6. Kombination nach einem der vorhergehenden Ansprüche, **dadurch gekennzeichnet, dass** jeder der Abschirmungsleiter (2) eine Mehrzahl von Unterleitern umfasst, die so angeordnet sind, dass sie eine Windung bilden.

7. Kombination nach Anspruch 1, **dadurch gekennzeichnet, dass** die Anzahl von Kernen (3) von Magnetmaterial kleiner ist als die Anzahl der Ursprungsleiter (1).

8. Kombination nach Anspruch 1, **dadurch gekennzeichnet, dass** jeder der Magnetkerne (3) einen Satz von Ursprungsleitern (1) und einen jeweiligen Satz von Abschirmungsleitern (2) verknüpft.

9. Kombination nach Anspruch 1, **dadurch gekennzeichnet, dass** jeder der Magnetkerne (3) ein Gelenk umfasst.

10. Kombination nach Anspruch 1 oder 9, **dadurch gekennzeichnet, dass** jeder der Magnetkerne (3) von zwei Halbschalen gebildet ist, die um die Stromleitungen herum während der Installation der Stromleitungen oder sogar danach angeordnet werden sollen.

11. Kombination nach einem der vorhergehenden Ansprüche, **dadurch gekennzeichnet, dass** das Abschirmungssystem mit dem Anfang der Niederspannungsleitungen in den Transformatorstationen verwendet wird.

**Revendications**

1. Combinaison d'une pluralité de conducteurs source (1) et un système de protection destiné à atténuer le champ magnétique produit par ladite pluralité de conducteurs source (1) traversés par des courants, dans laquelle les conducteurs source (1) sont des lignes d'alimentation électrique destinées à acheminer et à distribuer une énergie électrique, le système comprenant :

- une pluralité de conducteurs de protection (2) associés à ladite pluralité de conducteurs source (1), chacun desdits conducteurs de protection (2) étant parallèle à un étirement respectif de conducteur source (1) ; et
- une pluralité de noyaux magnétiques (3) qui concatènent lesdits conducteurs source (1) et lesdits conducteurs de protection (2) de façon à assurer un couplage magnétique entre lesdits conducteurs source (1) et lesdits conducteurs de protection (2),

dans laquelle les conducteurs de protection (2) de ladite pluralité sont reliés les uns aux autres de façon à former un circuit fermé, et sont traversés par des courants induits par ledit couplage magnétique
dans laquelle le courant qui traverse chacun desdits conducteurs de protection (2) est en opposition de phase avec le courant qui traverse le conducteur source respectif (1),
**caractérisée en ce que** chacun desdits noyaux magnétiques (3) possède une forme toroïdale avec une ouverture interne dans laquelle s'étendent au moins l'un desdits conducteurs source (1) et au moins l'un desdits conducteurs de protection (2), chacun desdits noyaux magnétiques (3) étant configuré pour être ouvrable afin de permettre son installation, de sorte que les noyaux magnétiques puissent être positionnés autour desdites lignes d'alimentation pendant l'installation, et le système est applicable à des étirements de lignes d'alimentation.

**2.** Combinaison selon la revendication 1, **caractérisée en ce que** :

- un conducteur de protection respectif (2) et un noyau magnétique respectif (3) sont associés à chaque conducteur source (1) ;
- chaque conducteur source (1) concatène ledit noyau magnétique (3) $N_1$ fois ; et
- chaque conducteur de protection (2) concatène ledit noyau magnétique (3) $N_2$ fois par le biais d'un enroulement (4) prévu sur ledit noyau magnétique (3).

**3.** Combinaison selon la revendication 1, **caractérisée en ce que** :

- chaque conducteur source (1) concatène ledit noyau magnétique (3) une seule fois ; et
- chaque conducteur de protection (2) concatène ledit noyau magnétique (3) une seule fois.

**4.** Combinaison selon la revendication 2 ou 3, **caractérisée en ce que** chaque noyau magnétique (3), avec le conducteur source respectif (1) et le conducteur de protection respectif (2), offre un transformateur.

**5.** Combinaison selon la revendication 4, **caractérisée en ce que** l'enroulement principal dudit transformateur est prévu par un conducteur source (1), et l'enroulement secondaire dudit transformateur est prévu par le conducteur de protection respectif (2), et les courants qui circulent, respectivement, dans le conducteur source (1) et dans le conducteur de protection (2) sont liés par un rapport de transformateur égal à $N_1/N_2$.

**6.** Combinaison selon l'une quelconque des revendications précédentes, **caractérisée en ce que** chacun desdits conducteurs de protection (2) comprend une pluralité de sous-conducteurs disposés de façon à former un tour.

**7.** Combinaison selon la revendication 1, **caractérisée en ce que** le nombre de noyaux (3) du matériau magnétique est inférieur au nombre desdits conducteurs source (1).

**8.** Combinaison selon la revendication 1, **caractérisée en ce que** chacun des noyaux magnétiques (3) concatène un groupe de conducteurs source (1) et un groupe respectif de conducteurs de protection (2).

**9.** Combinaison selon la revendication 1, **caractérisée en ce que** chacun desdits noyaux magnétiques (3) comprend une charnière.

**10.** Combinaison selon la revendication 1 ou 9, **caractérisée en ce que** chacun desdits noyaux magnétiques (3) est constitué de deux demi-coques à positionner autour des lignes d'alimentation pendant l'installation des lignes d'alimentation ou après.

**11.** Combinaison selon l'une quelconque des revendications précédentes, **caractérisée en ce que** ledit système de protection est appliqué au début des lignes à basse tension dans les postes de transformation.

*FIG. 1*

EP 2 250 654 B1

**FIG. 2**

FIG. 3

*FIG. 4*

*FIG. 5B*

*FIG. 5A*

EP 2 250 654 B1

**FIG. 6**

*FIG. 7*

2

3

1

5

**FIG. 8**

**FIG. 9**

*FIG. 10*

## REFERENCES CITED IN THE DESCRIPTION

**Patent documents cited in the description**

- SE 460447 B

- DE 19831178

**Non-patent literature cited in the description**

- New double-shielded power cables generating low magnetic field levels. **D'AMORE M et al.** ELECTRO-MAGNETIC COMPATIBILITY, 2005. EMC 2005. 2005 INTERNATIONAL SYMP OSIUM ON CHICA-GO. IEEE, 08 August 2005, vol. 1, 179-184